# FASCICULE DE BREVET EUROPEEN

(11) **EP 3 397 036 B1**
(45) Date de publication et mention de la délivrance du brevet: **11.08.2021**
(21) Numéro de dépôt: 18169297.1
(22) Date de dépôt: 25.04.2018
(51) Int. Cl.: H05K 7/14, H02B 13/025, H02B 1/28

(54) **CAPOT AMÉLIORÉ POUR UN COFFRE ÉLECTRIQUE ET COFFRE ÉLECTRIQUE COMPORTANT UN TEL CAPOT**
VERBESSERTE ABDECKUNG FÜR EINEN ELEKTRISCHEN SCHALTSCHRANK, UND ELEKTRISCHER SCHALTSCHRANK, DER EINE SOLCHE ABDECKUNG UMFASST
IMPROVED COVER FOR AN ELECTRIC CUBICLE AND ELECTRIC CUBICLE COMPRISING SUCH A COVER

(30) Priorité: 25.04.2017 FR 1753574
(43) Date de publication de la demande: 31.10.2018
(73) Titulaire: ALSTOM Transport Technologies, 93400 Saint-Ouen (FR)
(72) Inventeur: DELVAL, Damien, 59600 ASSEVENT (FR)
(74) Mandataire: Lavoix

(56) Documents cités:
- DE-A1- 3 840 240
- DE-B- 1 059 079
- DE-B- 1 201 448
- DE-B3-102013 208 831
- US-A- 5 878 905

## Description

L'invention a pour domaine celui des capots pour un coffre électrique du type comportant : une ouverture sur une paroi principale du capot ; un volet mobile qui, sous l'effet d'une surpression à l'intérieur du coffre électrique, est capable de pivoter entre une position fermée d'obturation de l'ouverture et une position ouverte de communication fluidique à travers l'ouverture entre l'intérieur et l'extérieur du coffre électrique, une face intérieure du volet, orientée vers l'intérieur du coffre électrique, étant munie d'un canal propre, en position ouverte du volet, à guider un flux gazeux depuis l'intérieur du coffre électrique vers l'extérieur du coffre électrique, le canal étant inscrit dans un contour de l'ouverture pour autoriser le déplacement du volet, le canal comportant un orifice de sortie propre à guider le flux gazeux selon une direction principale perpendiculaire à la direction d'un axe de pivotement du volet, et le canal comportant des première et seconde parois latérales, montées à angle droit sur la face inférieure du volet, les première et seconde parois latérales bouchant latéralement, en position ouverte du volet, un intervalle entre l'ouverture et la face inférieure du volet.

Les documents DE 38 40 240 A1, DE 12 01 448 B, DE 10 2013 208831 B3 et DE 10 59 079 B divulguent des capots pour coffre électrique du type précité.

Lors du fonctionnement d'un coffre électrique contenant des composants électriques et/ou électroniques (tels que par exemple des transistors de puissance) il peut arriver qu'un composant explose, par exemple sous l'effet d'un arc électrique ou d'une surchauffe liée à un dysfonctionnement.

Afin de ne pas détériorer l'ensemble des composants électriques et/ou électroniques du coffre électrique, il est nécessaire de pouvoir évacuer vers l'extérieur du coffre la surpression causée par la destruction de ce composant.

On connait un capot fusible dont la paroi principale est amincie selon des lignes de faiblesse. En cas de surpression, le capot est propre à s'ouvrir le long de ces lignes de faiblesse de manière à permettre l'évacuation vers l'extérieur du coffre du flux gazeux et éventuellement des débris du composant détruit.

Cependant, ce type de capot fusible ne peut servir qu'une fois, puisque la déformation de sa paroi principale lors de l'ouverture n'est pas réversible. Il est donc nécessaire de remplacer le capot systématiquement après ouverture.

Par ailleurs, ce type de capot fusible présente une étanchéité qui n'est pas garantie du fait de la présence de ces lignes de faiblesse.

On connaît également, par le document US 5 878 905, un capot présentant une ouverture obturée par un volet. Le volet, monté pivotant sur le capot, est propre à passer d'une position fermée à une position ouverte sous l'effet d'une surpression à l'intérieur du coffre. Un vérin fixé d'une part à une paroi du coffre et d'autre part au bord du volet maintient le volet en position fermée tant que la surpression à l'intérieur du coffre n'est pas supérieure à un seuil prédéterminé. Le vérin permet également de rabattre en position fermée le volet après ouverture et rééquilibrage des pressions entre l'intérieur et l'extérieur du coffre. Le capot est par conséquent réversible.

Cependant, le capot réversible venant d'être présenté présente l'inconvénient de conduire à l'évacuation du flux gazeux, et éventuellement des débris du composant détruit, à travers l'ouverture dans toutes les directions, avec le risque que ce flux gazeux soit émis vers une personne située à proximité du coffre (opérateur ou passager lorsqu'un tel coffre équipe un véhicule, notamment un véhicule ferroviaire).

L'invention a donc pour but de résoudre ce problème, en présentant notamment un capot amélioré tout au moins sur le plan de la sécurité de fonctionnement du coffre qu'il équipe.

L'invention a donc pour objet un capot pour un coffre électrique et un coffre selon les revendications annexées.

L'invention et ses avantages seront mieux compris à la lecture de la description détaillée qui va suivre d'un mode de réalisation particulier, donné uniquement à titre d'exemple illustratif et non limitatif, la description étant faite en se référant aux dessins annexés sur lesquels :
- la figure 1 est une vue en perspective cavalière d'un coffre, dont une face est obturée par un capot selon un mode de réalisation préféré de l'invention ;
- la figure 2 est une coupe du capot selon la ligne II-II de la figure 1, le capot étant fermé ; et
- la figure 3 est une vue de côté du capot, celui-ci étant ouvert.

En se référant aux figures, un coffre électrique 1, de forme sensible parallélépipédique, est obturé sur l'une de ses faces par un capot 10.

Un trièdre XYZ est associé au coffre 1.

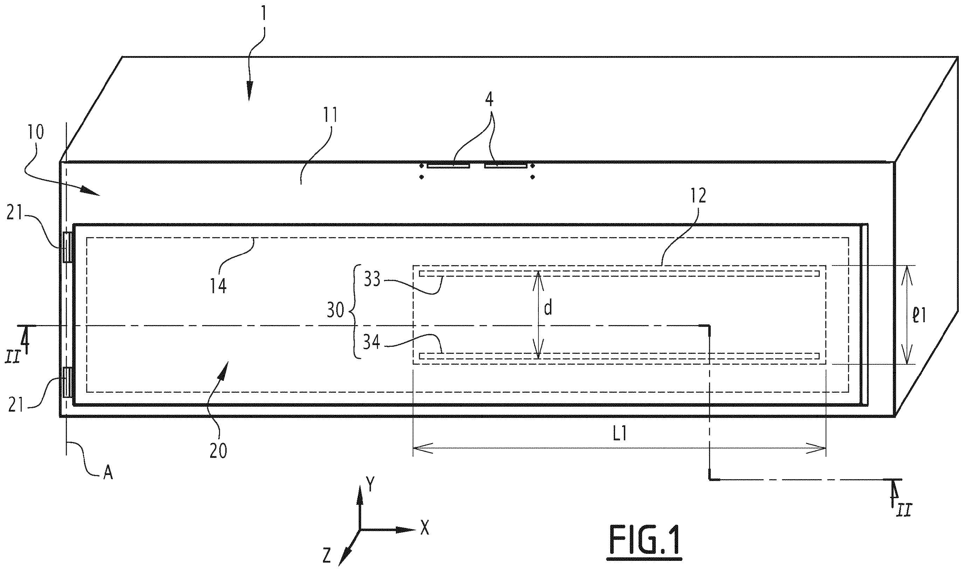

Le capot 10 est par exemple monté sur un bâti du coffre 1 par l'intermédiaire de charnière, représenté schématiquement sur la figure 1 et référencé par le chiffre 4, autorisant le pivotement du capot 2 le long d'un axe parallèle à la direction X de manière à autoriser l'accès à l'intérieur du coffre 1, par exemple pour installer ou assurer la maintenance des composants électriques ou électroniques logés dans le coffre 1.

Le capot 10 comporte une paroi principale 11, plane et de forme rectangulaire. Elle repose dans le plan XY.

La paroi principale 11 est munie d'une ouverture 12, qui, sur la figure 1, est masquée par un volet 20.

L'ouverture 12 traverse la paroi principale 11.

L'ouverture 12 présente un contour sensiblement rectangulaire. Elle présente une longueur L1 selon la direction X et une largeur I1 selon la direction Y.

Le volet 20 est monté mobile sur la face extérieure de la paroi principale 11. Plus particulièrement, une première extrémité longitudinale du volet 20 est montée par deux charnières 21 sur la face extérieure de la paroi principale 11 du capot 10.

Le volet 20 est ainsi propre à pivoter autour d'un axe de pivotement A s'étendant selon la direction Y.

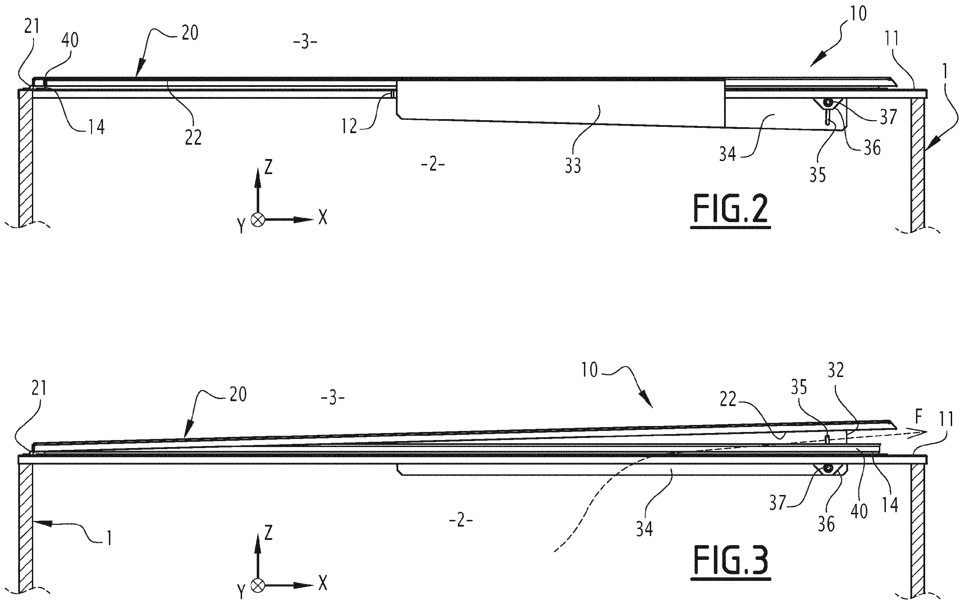

Le volet 20 est propre à se déplacer entre une position fermée, représentée sur la figure 2, et une position ouverte, représentée sur la figure 3.

Dans sa position fermée, le volet 20 obture le coffre 1 de manière étanche pour isoler l'intérieur 2 du coffre 1 de l'extérieur 3 du coffre 1. Dans le mode de réalisation représenté ici en détail, la paroi principale 11 porte, sur sa surface extérieure, un bord relevé 14 qui entoure l'ouverture 12 tout en étant reçu à l'intérieur du contour du volet 20.

Le bord relevé 14 porte un joint 40 (visible sur la figure 2). Dans la position fermée du volet 20, la face interne 22 du volet 20, orientée vers l'ouverture 12 et l'intérieur 2 du coffre 1, vient en appui du joint 40 de manière à assurer l'étanchéité du coffre 1.

Par ailleurs, la face intérieure 22 du volet 20 comporte un canal 30.

Le canal 30 est délimité transversalement par une première paroi latérale 33 et une seconde paroi latérale 34.

Les première et seconde parois latérales 33, 34 sont planes et fixées, par exemple par soudage, à angle droit sur la face intérieure 22 du volet 20.

Les première et seconde parois latérales 33, 34 sont disposées parallèlement l'une de l'autre de manière à être située à une distance d inférieure à la largeur I1 de l'ouverture 12.

Les première et seconde parois latérales 33, 34 présentent une forme trapézoïdale. La longueur des parois latérales 33, 34 (correspondant à la hauteur du trapèze qu'elles forment) est légèrement inférieure à la longueur L1 de l'ouverture 12.

Ainsi, le canal 30 est propre à être reçu à l'intérieur de l'ouverture 12 en position fermée du volet 20 et à ne pas gêner l'ouverture de celui-ci lors de la survenue d'une surpression à l'intérieure 2 du coffre 1.

Comme représenté sur la figure 3, en position ouverte du volet 20, les première et seconde parois latérales 33, 34 viennent boucher latéralement l'intervalle entre l'ouverture 12 et la face inférieure 22 du volet 20.

La hauteur maximale des parois latérales 33, 34 (correspondant à la base du trapèze qu'elles forment) est supérieure à la distance entre la face extérieure de la paroi principale 11 et la face inférieure 22 du volet 20.

Le canal 30 débouche à l'extérieure 3 du coffre 1 selon un orifice de sortie 32.

Ainsi, le canal 30 met en communication fluidique l'intérieur 2 et l'extérieur 3 du coffre 1, comme l'indique la flèche F de la figure 3.

Ainsi, en cas de surpression, le flux gazeux est canalisé à travers l'ouverture 12 entre les première et seconde parois latérales 33 et 34 vers l'orifice de sortie 32. Il est par conséquent expulsé de l'intérieur du coffre 1 vers l'extérieur 3 du coffre 1 latéralement.

Plus précisément, le flux gazeux est évacué perpendiculairement à la direction de l'axe A de pivotement du volet 20 et à faible angle par rapport au plan de la paroi principale 11 du capot 10.

Ainsi, le flux gazeux (formée de fumées composées de produits chimiques variés) et éventuellement les débris qu'il entraine sont éjectés hors du coffre, latéralement, d'une manière qui permet de diminuer les risques pour les personnes environnantes.

Comme visible sur les figures 2 et 3, les première et seconde parois latérales 33, 34 sont respectivement munies de fentes 35 arquées. Le centre de ces fentes 35 repose sur l'axe A de pivotement du volet.

La face intérieure de la paroi principale 11 du capot 10 est munie de part et d'autre de l'ouverture 12 de supports 36 portant des pions 37, qui sont propres à coopérer avec des fentes 35.

Un pion 37 est par exemple constitué d'une vis dynamométrique dont le serrage permet de définir un seuil de surpression en dessous duquel le volet 20 reste dans sa position fermée et au-dessus duquel le volet 20 se déplace pour passer dans sa position ouverte.

L'extension des fentes 35 permet de définir l'intervalle angulaire de déplacement du volet 20 et par conséquent sa position ouverte.

## Revendications

1. Capot (10) pour un coffre électrique (1), comportant :
- Une ouverture (12) sur une paroi principale (11) du capot (10) ;
- Un volet (20) mobile qui, sous l'effet d'une surpression à l'intérieur (2) du coffre électrique (1), est capable de pivoter entre une position fermée d'obturation de l'ouverture (12) et une position ouverte de communication fluidique à travers l'ouverture (12) entre l'intérieur (2) et l'extérieur (3) du coffre électrique (1),
une face intérieure (22) du volet (20), orientée vers l'intérieur (2) du coffre électrique (1), étant munie d'un canal (30) propre, en position ouverte du volet, à guider un flux gazeux depuis l'intérieur (2) du coffre électrique (1) vers l'extérieur (3) du coffre électrique (1), le canal (30) étant inscrit dans un contour de l'ouverture (12) pour autoriser le déplacement du volet (20), le canal (30) comportant un orifice de sortie (32) propre à guider le flux gazeux selon une direction principale (X) perpendiculaire à la direction d'un axe (A) de pivotement du volet (20), et le canal (30) comportant des première et seconde parois latérales (33, 34), montées à angle droit sur la face intérieure (22) du volet (20), les première et seconde parois latérales bouchant latéralement, en position ouverte du volet (20), un intervalle entre l'ouverture (12) et la face intérieure (22) du volet (20), **caractérisé en ce que** la première et/ou la seconde paroi latérale (33, 34) comporte une fente (35, 36) en arc de cercle, dont le centre est situé sur l'axe (A) de pivotement du volet (20) et dans lequel une face interne de la paroi principale (11) du capot (10) porte un pion (37, 38) reçu dans la fente pour guider en ouverture le volet (20),
et **en ce que** le pion (37, 38) est une vis dynamométrique propre à maintenir le volet (20) en position fermée tant que la pression à l'intérieur du coffre électrique (1) reste inférieure à une pression seuil.

2. Capot (10) selon la revendication 1, dans lequel le volet (20) est monté pivotant sur une face externe de la paroi principale (11) du capot (10).

3. Capot (10) selon l'une quelconque des revendications 1 à 2, dans lequel la paroi principale (11) du capot (10) comporte un bord relevé (14) entourant l'ouverture (12), le bord relevé (14) portant un joint d'étanchéité (40), et dans lequel la face intérieure (22) du volet (20) vient en appui du joint (40) dans la position fermée du volet (20) pour assurer l'étanchéité du coffre électrique (1).

4. Capot (10) selon l'une quelconque des revendications 1 à 3, dans lequel la fente (35, 36) autorise un déplacement du volet (20) sur un intervalle angulaire prédéterminé.

5. Capot (10) selon l'une quelconque des revendications 1 à 4, dans lequel l'ouverture (12) est sensiblement rectangulaire, un axe (A) de pivotement du volet (20) est parallèle à une extrémité longitudinale de l'ouverture (12), les première et seconde parois (33, 34) sont espacées l'une de l'autre d'une distance inférieure à la largeur de l'ouverture (12) et présentent chacune une longueur légèrement inférieure à celle de l'ouverture (12) et une hauteur, évaluée selon une direction perpendiculaire à la paroi principale (11) du capot (10), supérieure ou égale à la plus grande distance entre l'ouverture (12) et la face intérieure (22) du volet (20), en position ouvert du volet.

6. Coffre électrique (1), **caractérisé en ce qu'**il comporte un capot conforme au capot (10) selon l'une quelconque des revendications 1 à 5.

## Patentansprüche

1. Abdeckung (10) für einen Schaltkasten (1), aufweisend:
- eine Öffnung (12) an einer Hauptwand (11) der Abdeckung (10),
- eine bewegbare Klappe (20), die unter der Wirkung eines Überdrucks im Inneren (2) des Schaltkastens (1) in der Lage ist, zwischen einer Schließposition zum Verschließen der Öffnung (12) und einer Öffnungsposition zur Fluidkommunikation durch die Öffnung (12) hindurch zwischen dem Inneren (2) und dem Äußeren (3) des elektrischen Kastens (1) zu schwenken,
wobei eine Innenseite (22) der Klappe (20), die in Richtung zum Inneren (2) des Schaltkastens (1) ausgerichtet ist, mit einem Kanal (30) ausgestattet ist, der geeignet ist, um in der Öffnungsposition der Klappe einen Gasstrom vom Inneren (2) des Schaltkastens (1) in Richtung zum Äußeren (3) des Schaltkastens (1) zu leiten, wobei der Kanal (30) in einen Umriss der Öffnung (12) aufgenommen ist, um die Bewegung der Klappe (20) zu ermöglichen, wobei der Kanal (30) eine Ausgangsöffnung (32) aufweist, die geeignet ist, um den Gasstrom entlang einer Hauptrichtung (X) senkrecht zu der Richtung einer Schwenkachse (A) der Klappe (20) zu leiten, und wobei der Kanal (30) eine erste und eine zweite Seitenwand (33, 34) aufweist, die im rechten Winkel an der Innenseite (22) der Klappe (20) montiert sind, wobei die erste und die zweite Seitenwand in der Öffnungsposition der Klappe (20) einen Abstand zwischen der Öffnung (12) und der Innenseite (22) der Klappe (20) seitlich blockieren,
**dadurch gekennzeichnet, dass** die erste und/oder die zweite Seitenwand (33, 34) einen kreisbogenförmigen Schlitz (35, 36) aufweist, dessen Mittelpunkt auf der Schwenkachse (A) der Klappe (20) liegt, und wobei eine Innenseite der Hauptwand (11) der Abdeckung (10) einen im Schlitz aufgenommenen Zapfen (37, 38) zum Führen der Klappe (20) beim Öffnen trägt,
und dass der Zapfen (37, 38) eine dynamometrische Schraube ist, die geeignet ist, um die Klappe (20) in der Schließposition zu halten, solange der Druck im Inneren des Schaltkastens (1) unterhalb eines Schwellendrucks bleibt.

2. Abdeckung (10) gemäß Anspruch 1, wobei die Klappe (20) schwenkbar an einer Außenseite der Hauptwand (11) der Abdeckung (10) montiert ist.

3. Abdeckung (10) gemäß irgendeinem der Ansprüche 1 bis 2, wobei die Hauptwand (11) der Abdeckung (10) einen hochgezogenen Rand (14) aufweist, der die Öffnung (12) umgibt, wobei der hochgezogene Rand (14) eine Dichtung (40) trägt, und wobei die Innenseite (22) der Klappe (20) in der Schließposition der Klappe (20) an die Dichtung (40) anstößt, um die Abdichtung des Schaltkastens (1) sicherzustellen.

4. Abdeckung (10) gemäß irgendeinem der Ansprüche 1 bis 3, wobei der Schlitz (35, 36) eine Bewegung der Klappe (20) über einen vorbestimmten Winkelabstand ermöglicht.

5. Abdeckung (10) gemäß irgendeinem der Ansprüche 1 bis 4, wobei die Öffnung (12) im Wesentlichen rechteckig ist, eine Schwenkachse (A) der Klappe (20) parallel zu einem Längsende der Öffnung (12) verläuft, die erste und die zweite Wand (33, 34) in einem Abstand voneinander angeordnet sind, der kleiner als die Breite der Öffnung (12) ist, und jeweils eine Länge, die etwas kleiner als die der Öffnung (12) ist, und eine Höhe haben, die entlang einer Richtung senkrecht zu der Hauptwand (11) der Abdeckung (10) bemessen ist, die größer oder gleich dem größten Abstand zwischen der Öffnung (12) und der Innenseite (22) der Klappe (20) in der Öffnungsposition der Klappe ist.

6. Schaltkasten (1), **dadurch gekennzeichnet, dass** er eine Abdeckung gemäß der Abdeckung (10) gemäß irgendeinem der Ansprüche 1 bis 5 aufweist.

## Claims

1. Cover (10) for an electric cubicle (1), comprising:
- An opening (12) on a main wall (11) of the cover (10);
- A mobile flap (20), which, due to an overpressure in the interior (2) of the electric cubicle (1), is capable of pivoting between a closed position of obstructing the opening (12) and an open position of fluid communication through the opening (12) between the interior (2) and exterior (3) of the electric cubicle (1),
an interior face (22) of the flap (20), oriented toward the interior (2) of the electric cubicle (1), being equipped with a channel (30) capable, when the flap is in its open position, of guiding a gas flow from the interior (2) of the electric cubicle (1) to the exterior (3) of the electric cubicle (1), the channel (30) being inscribed in a perimeter of the opening (12) to allow the movement of the flap (20), the channel (30) comprising an outlet orifice (32) able to guide the gas flow in a main direction (X) perpendicular to the direction of an axis (A) on which the flap (20) pivots, and the channel (30) comprising first and second side walls (33, 34), installed at a right angle to the interior face (22) of the flap (20), the first and second side walls opening laterally, when the flap (20) is in its open position, at an interval between the opening (12) and the interior face (22) of the flap (20),
**characterized in that** the first and/or second side wall (33, 34) comprises a slot (35, 36) in the form of an arc, whose the centre is located on the axis (A) on which the flap (20) pivots, and wherein an inner face of the main wall (11) of the cover (10) bears a rod (37, 38) housed in the slot to guide the flap (20) open,
and **in that** the rod (37, 38) is a torque wrench capable of keeping the flap (20) in a closed position as long as the pressure inside the electric cubicle (1) remains below a threshold pressure.

2. A cover (10) according to claim 1, wherein the flap (20) is pivotably mounted on an outer face of the main wall (11) of the cover (10).

3. A cover (10) according to any one of the claims 1 to 2, wherein the main wall (11) of the cover (10) comprises a raised edge (14) surrounding the opening (12), the raised edge (14) bearing a seal (40), and wherein the interior face (22) of the flap (20) rests against the seal (40) when the flap (20) is in the closed position to ensure the sealing of the electric cubicle (1).

4. A cover (10) according to any one of the claims 1 to 3, wherein the slot (35, 36) allows the flap (20) to move within a predetermined angular interval.

5. A cover (10) according to any one of the claims 1 to 4, wherein the opening (12) is substantially rectangular, an axis (A) on which the flap (20) pivots is parallel to a longitudinal end of the opening (12), the first and second walls (33, 34) are spaced apart from one another by a distance less than the width of the opening (12) and each have a length slightly less than that of the opening (12) and a height, as measured along a direction perpendicular to the main wall (11) of the cover (10), greater than or equal to the greatest distance between the opening (12) and the interior face (22) of the flap (20), when the flap is in its open position.

6. An electric cubicle (1), **characterized in that** it comprises a cover compliant with the cover (10) according to any one of the claims 1 to 5.
